# EUROPÄISCHE PATENTANMELDUNG

(11) **EP 4 415 493 A1**
(43) Veröffentlichungstag der Anmeldung: **14.08.2024**
(21) Anmeldenummer: 23155361.1
(22) Anmeldetag: 07.02.2023
(51) Int. Cl.: H05K 7/20

(54) **HALBLEITERMODULANORDNUNG MIT ZUMINDEST EINEM HALBLEITERELEMENT**

(71) Anmelder: Siemens Aktiengesellschaft, 80333 München (DE)
(72) Erfinder: Sewiolo, Benjamin, 90587 Obermichelbach (DE)
(74) Vertreter: Siemens Patent Attorneys

(57) **Zusammenfassung**

Die Erfindung betrifft eine Halbleiteranordnung (2), insbesondere Leistungshalbleiteranordnung für einen Stromrichter (66), mit zumindest einem Halbleiterelement (4), wobei das zumindest eine Halbleiterelement (4) in einem geschlossenen Gehäuse (6) angeordnet ist. Um die Rezyklierbarkeit der Halbleiteranordnung (2) zu verbessern, wird vorgeschlagen, dass das Halbleiterelement (4) in unmittelbarem Kontakt mit einer Kühlmittelströmung (42) einer elektrisch isolierenden Kühlflüssigkeit (40), insbesondere Inertflüssigkeit, steht.

## Beschreibung

Die Erfindung betrifft eine Halbleiteranordnung, insbesondere eine Leistungshalbleiteranordnung für einen Stromrichter, mit zumindest einem Halbleiterelement, wobei das zumindest eine Halbleiterelement in einem geschlossenen Gehäuse angeordnet ist.

Ferner betrifft die Erfindung einen Stromrichter mit mindestens einer derartigen Halbleiteranordnung.

Überdies betrifft die Erfindung ein Verfahren zur Herstellung einer Halbleiteranordnung, insbesondere einer Leistungshalbleiteranordnung für einen Stromrichter, mit zumindest einem Halbleiterelement, wobei das zumindest eine Halbleiterelement in einem geschlossenen Gehäuse angeordnet ist.

Weiterhin betrifft die Erfindung die Verwendung einer Kühlmittelströmung einer elektrisch isolierenden Kühlflüssigkeit, insbesondere Inertflüssigkeit, zum Kühlen eines Halbleiterelements in einem geschlossenen Gehäuse.

Darüber hinaus betrifft die Erfindung ein Computerprogrammprodukt, welches als digitaler Zwilling einer derartigen Halbleiteranordnung ausgebildet ist.

Derartige Halbleiteranordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. Üblicherweise umfassen derartige Halbleiteranordnungen ein Gehäuse, in welchem zumindest ein Halbleiterelement angeordnet ist. Ein derartiges Halbleiterelement kann unter anderem ein Transistor sein. Innerhalb des Gehäuses ist üblicherweise ein Weichverguss, insbesondere ein Silikonverguss, zum Schutz des zumindest einen Halbleiterelements vorgesehen.

Die Offenlegungsschrift WO 2022/033745 A1 beschreibt ein Leistungsmodul mit mindestens einer Leistungseinheit, welche mindestens einen Leistungshalbleiter und ein Substrat umfasst, wobei die mindestens eine Leistungseinheit zumindest teilweise von einem Gehäuse umgeben ist. Das Gehäuse ist mit einem Weichverguss, insbesondere mit einem Silikonverguss, gefüllt.

Umwelttechnische Aspekte gewinnen auch in der Elektronikentwicklung immer mehr an Bedeutung. Insbesondere rückt eine verbesserte Rezyklierbarkeit in den Fokus. Die Rezyklierbarkeit aber auch ein Reparaturaufwand werden beispielsweise durch den Wegfall von stoffschlüssigen Verbindungen, welche beispielsweise durch Löten, Sintern oder Schweißen herstellbar sind, verbessert.

Die Offenlegungsschrift EP 3 926 670 A1 beschreibt ein Leistungshalbleitermodul mit zumindest einem Leistungshalbleiterelement. Um den erforderlichen Bauraum des Leistungshalbleitermoduls zu verringern und dessen Lebensdauer zu erhöhen, wird vorgeschlagen, dass das zumindest eine Leistungshalbleiterelement über eine dielektrische Materiallage mit einem Kühlelement in einer elektrisch isolierenden und thermisch leitfähigen Verbindung steht, wobei die dielektrische Materiallage flächig auf einer Oberfläche des Kühlelements aufliegt und mittels einer orthogonal zur Oberfläche des Kühlelements wirkenden ersten Kraft kraftschlüssig mit dem Kühlelement verbunden ist.

Die Offenlegungsschrift WO 2018/046165 A1 beschreibt ein Leistungsmodul mit einem ober- und unterseitig zu kontaktierenden Halbleiterbauelement, wobei das Halbleiterbauelement oberseitig durch eine Leadframe-Matrix mittels Anpressdruck elektrisch zu kontaktieren ist.

Ein Weichverguss ist, beispielsweise bei Rezyklierungsvorgängen, sehr schwer zu entfernen. Vor diesem Hintergrund ist es eine Aufgabe der vorliegenden Erfindung, die Rezyklierbarkeit einer Halbleiteranordnung zu verbessern.

Diese Aufgabe wird erfindungsgemäß durch eine Halbleiteranordnung der eingangs genannten Art dadurch gelöst, dass das Halbleiterelement in unmittelbarem Kontakt mit einer Kühlmittelströmung einer elektrisch isolierenden Kühlflüssigkeit, insbesondere Inertflüssigkeit, steht.

Ferner wird die Aufgabe erfindungsgemäß gelöst durch einen Stromrichter mit mindestens einer derartigen Halbleiteranordnung.

Überdies wird die Aufgabe erfindungsgemäß durch Verfahren der eingangs genannten Art dadurch gelöst, dass das Halbleiterelement in unmittelbarem Kontakt mit einer Kühlmittelströmung einer elektrisch isolierenden Kühlflüssigkeit, insbesondere Inertflüssigkeit, gebracht wird.

Weiterhin wird die Aufgabe erfindungsgemäß durch die Verwendung einer Kühlmittelströmung einer elektrisch isolierenden Kühlflüssigkeit, insbesondere Inertflüssigkeit, zum Kühlen eines Halbleiterelements in einem geschlossenen Gehäuse, wobei die Kühlmittelströmung in unmittelbarem Kontakt mit dem zumindest einen Halbleiterelement steht.

Darüber hinaus wird die Aufgabe erfindungsgemäß durch ein Computerprogrammprodukt, welches als digitaler Zwilling einer derartigen Halbleiteranordnung ausgebildet ist und welches bei einem Simulieren des Betriebsverhaltens einer korrespondierend ausgebildeten Halbleiteranordnung verwendet wird.

Die in Bezug auf die Halbleiteranordnung nachstehend angeführten Vorteile und bevorzugten Ausgestaltungen lassen sich sinngemäß auf den Stromrichter, das Verfahren, die Verwendung und das Computerprogrammprodukt übertragen.

Der Erfindung liegt die Überlegung zugrunde, die Rezyklierbarkeit einer Halbleiteranordnung dadurch zu verbessern, dass ein üblicherweise verwendeter Weichverguss durch eine elektrisch isolierende Kühlflüssigkeit ersetzt wird. Ein geschlossenes Gehäuse der Halbleiteranordnung, in welchem zumindest ein Halbleiterelement angeordnet ist, wird zumindest teilweise mit der elektrisch isolierenden Kühlflüssigkeit derartig befüllt, dass das Halbleiterelement mit einer Kühlmittelströmung der elektrisch isolierenden Kühlflüssigkeit in unmittelbarem Kontakt steht. Beispielsweise ist das Halbleiterelement als vertikaler Transistor, insbesondere als IGBT oder vertikaler SiC-MOSFET, ausgeführt. Das Gehäuse ist beispielsweise zumindest teilweise aus einem Kunststoff hergestellt und kann fluiddicht geschlossen sein, um einen Verlust der elektrisch isolierenden Kühlflüssigkeit zu minimieren. Durch die Kühlmittelströmung der elektrisch isolierenden Kühlflüssigkeit wird eine verbesserte Entwärmung des zumindest einen Halbleiterelements erreicht. Insbesondere ist das Halbleiterelement zumindest teilweise von der Kühlmittelströmung umgeben. Die elektrisch isolierende Kühlflüssigkeit der Kühlmittelströmung ist insbesondere als Inertflüssigkeit ausgeführt, welche beispielsweise eine Durchschlagsfestigkeit von mindestens 10 kV/mm, insbesondere 20 kV/mm aufweist. Unter anderem kommen Galden^{®} HS 240, 3M^{™} Novec^{™} oder 3M^{™} Fluorinert^{™} als elektrisch isolierende Kühlflüssigkeit infrage. Ein einfaches Zerlegen zur Reparatur, zum Refurbishing oder zum Rezyklieren wird durch eine zumindest teilweise Befüllung des Gehäuses mit der elektrisch isolierenden Kühlflüssigkeit ermöglicht, wobei die Kühlmittelströmung, insbesondere durch die unmittelbare Kontaktierung mit dem zumindest einen Halbleiterelement, für eine verbesserten Wärmeabtransport sorgt, was sich unter anderem positiv auf die Lebensdauer der Halbleiteranordnung auswirkt, und höhere Leistungsdichten ermöglicht. Ferner werden Materialien und energieintensive Herstellungsprozesse eingespart.

Insbesondere ist das Betriebsverhalten der Halbleiteranordnung, welches maßgeblich durch die Kühlmittelströmung beeinflussbar ist, durch Abgleich mit einer korrespondierend ausgebildeten simulierten Halbleiteranordnung auf Plausibilität überprüfbar. Weiterhin kann ein Rezyklier-Prozess der Halbleiteranordnung simuliert und beispielsweise hinsichtlich einer Zerlegungsreihenfolge optimiert werden. Das Computerprogrammprodukt, das als sogenannter Digitaler Zwilling ausgebildet ist, erlaubt eine Modellierung zumindest der Halbleiteranordnung in einer Simulationsumgebung. Somit ist in einfacher Weise ein ausreichend realitätsnahes Prozessabbild bereitstellbar. Ein derartiger Digitaler Zwilling wird beispielsweise in der Druckschrift US 2017/286572 A1 beschrieben, wobei der Offenbarungsgehalt der Druckschrift US 2017/286572 A1 durch Verweisung in die vorliegende Anmeldung mit einbezogen wird. Das Computerprogrammprodukt kann monolithisch ausgebildet sein, also vollständig auf einer Hardwareplattform ausführbar. Alternativ kann das Computerprogrammprodukt modular ausgebildet sein und eine Mehrzahl an Teilprogrammen umfassen, die auf separaten Hardwareplattformen ausführbar sind und über eine kommunikative Datenverbindung zusammenwirken. Eine solche kommunikative Datenverbindung kann eine Netzwerkverbindung, eine Internetverbindung und/oder eine Mobilfunkverbindung sein. Ferner kann durch einen derartigen Digitalen Zwilling der Betrieb unter Einbezug der Kühlmittelströmung oder das Rezyklieren der Halbleiteranordnung oder gar eines Stromrichters, welcher zumindest eine derartige Halbleiteranordnung umfasst, per Simulation einfach und kostengünstig erprobt und/oder optimiert werden.

Eine weitere Ausführungsform sieht vor, dass das Halbleiterelement, insbesondere mittels eines ersten Presskontakts, kraftschlüssig mit einem Trägerelement verbunden ist. Ein derartiger Presskontakt kann unter anderem als Stromschiene, welche auch Busbar genannt wird, ausgeführt sein. Alternativ kann eine Feder, eine Schraube und/oder ein Bügel zur kraftschlüssigen Verbindung des Halbleiterelements zum Einsatz kommen. Eine derartige kraftschlüssige Verbindung des Halbleiterelements ist lösbar und beim Zerlegen zur Reparatur, zum Refurbishing oder zum Rezyklieren, insbesondere in Kombination mit der Füllung mit der elektrisch isolierenden Kühlflüssigkeit, einfach zu entfernen.

Eine weitere Ausführungsform sieht vor, dass das Trägerelement aus einem metallischen Werkstoff hergestellt ist, wobei das Halbleiterelement über eine dielektrische Materiallage elektrisch isolierend mit dem Trägerelement verbunden ist. Das Trägerelement kann unter anderem Kupfer, Aluminium oder einer deren Legierungen enthalten. Die dielektrische Materiallage kann unter anderem Aluminiumoxid, Aluminiumnitrid oder einen organischen elektrisch isolierenden und thermisch leitfähigen Werkstoff enthalten, um das Halbleiterelement elektrisch isolierend und thermisch leitend mit dem Trägerelement zu verbinden. Auf diese Weise ist das Halbleiterelement zusätzlich über das Trägerelement entwärmbar.

Eine weitere Ausführungsform sieht vor, dass das Trägerelement zumindest einen Kanal umfasst, durch welchen die Kühlmittelströmung verläuft. Beispielsweise ist der Kanal, durch welchen die elektrisch isolierende Kühlflüssigkeit strömt, mäanderförmig ausgeführt, sodass die während des Betriebes des Halbleiterelements entstehende Wärme beidseitig effizient durch die Kühlmittelströmung abgeführt wird.

Eine weitere Ausführungsform sieht vor, dass die Halbleiteranordnung eine zweite Leitvorrichtung, welche konfiguriert ist, die durch den zumindest einen Kanal des Trägerelements verlaufende Kühlmittelströmung über das Halbleiterelement zu leiten, umfasst. Eine derartige Leitvorrichtung kann unter anderem als Leitblech ausgeführt sein und dient dazu, die Kühlmittelströmung gezielt und gleichmäßig mit den Halbleiterelementen in Kontakt zu bringen.

Eine weitere Ausführungsform sieht vor, dass auf einer dem Halbleiterelement abgewandten Seite des Trägerelements ein weiteres Halbleiterelement, insbesondere mittels eines ersten Presskontakts, kraftschlüssig mit dem Trägerelement verbunden ist. Eine derartige beidseitige Anordnung der Halbleiterelemente führt zu einer höheren Integrations- bzw. Leistungsdichte der Anordnung. Ferner ist eine beidseitige kraftschlüssige Verbindung der Halbleiterelemente mit dem Trägerelement einfach zu entfernen, was das Zerlegen zur Reparatur, zum Refurbishing oder zum Rezyklieren zusätzlich vereinfacht.

Eine weitere Ausführungsform sieht vor, dass die elektrisch isolierende Kühlflüssigkeit als Phasenwechselkühlmittel ausgeführt ist. Beispielsweise ist Inertflüssigkeit wie 3M^{™} Novec^{™} mit unterschiedlichen Siedepunkten erhältlich. Somit kann der Siedepunkt so konfiguriert werden, dass die Inertflüssigkeit als Verdampfungskühlmittel bzw. Phasenwechselkühlmittel fungiert, um beispielsweise Wärmespitzen abzufedern. Durch die Phasenwechselkühlung werden, insbesondere im Vergleich zu einer reinen sensiblen Kühlung, höhere Wärmeübergangskoeffizienten ermöglicht.

Eine weitere Ausführungsform sieht vor, dass in dem geschlossenen Gehäuse eine Kondensationsvorrichtung zur Kondensation eines verdampften Kühlmittels angeordnet ist. Die Kondensationsvorrichtung kann unter anderem einen Wärmetauscher aufweisen. Durch eine derartige Anordnung wird eine Kondensation in Anwesenheit von Inertgasen, insbesondere Luft, nahe des Umgebungsdrucks ermöglicht, indem die hemmende Wirkung von Inertgasen durch Durchmischung vermieden wird.

Eine weitere Ausführungsform sieht vor, dass ein Sensor im Bereich des Halbleiterelements angeordnet wird, wobei die Kühlmittelströmung anhand von Sensordaten, welche mit Hilfe des Sensors ermittelt werden, geregelt wird. Der Sensor kann unter anderem einen Temperatursensor, einen Spannungssensor und/oder einen Stromsensor umfassen. Eine derartige Regelung der Kühlmittelströmung ermöglicht es beispielsweise die Temperatur des Halbleiterelements innerhalb eines vorbestimmten Temperaturbereichs zu halten.

Im Folgenden wird die Erfindung anhand der in den Figuren dargestellten Ausführungsbeispiele näher beschrieben und erläutert.

Es zeigen:
- FIG 1: eine schematische Schnittdarstellung einer ersten Ausführungsform einer Halbleiteranordnung,
- FIG 2: eine schematische Schnittdarstellung einer zweiten Ausführungsform einer Halbleiteranordnung,
- FIG 3: eine schematische Darstellung einer dritten Ausführungsform einer Halbleiteranordnung,
- FIG 4: eine schematische Darstellung einer vierte Ausführungsform einer Halbleiteranordnung,
- FIG 5: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

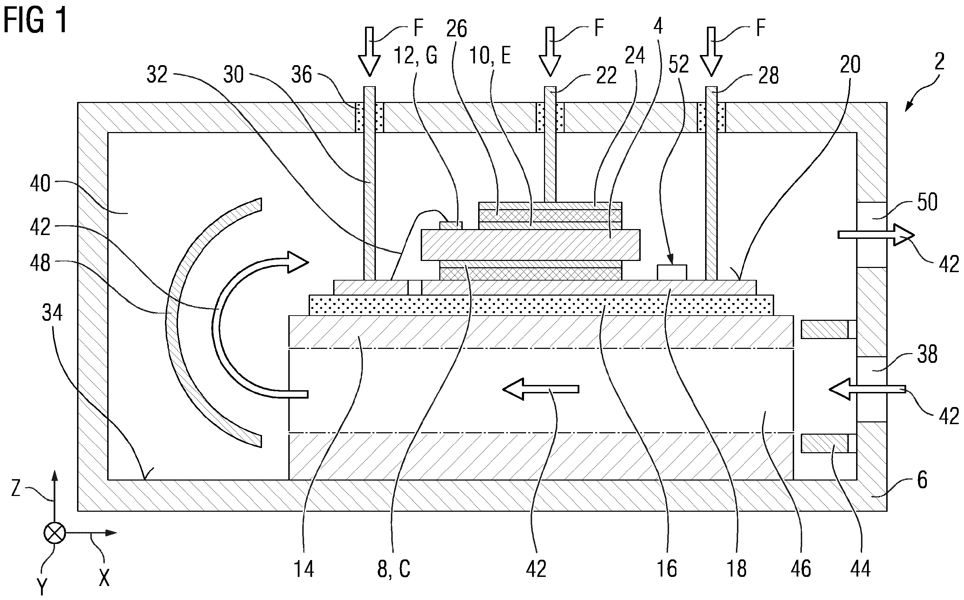

FIG 1 zeigt eine schematische Schnittdarstellung einer ersten Ausführungsform einer Halbleiteranordnung 2 mit einem Halbleiterelement 4, welches in einem geschlossenen Gehäuse 6 angeordnet ist. Beispielsweise ist das Halbleiterelement 4 als vertikaler Transistor, insbesondere als IGBT oder vertikaler SiC-MOSFET, ausgeführt. Das Halbleiterelement 4 weist einen ersten Leistungskontakt 8, insbesondere einen Kollektor-Kontakt C und auf einer gegenüberliegenden Seite einen zweiten Leistungskontakt 10, insbesondere einen Emitter-Kontakt E, und einen Steuerkontakt 12, insbesondere einen Gate-Kontakt G, auf.

Das Gehäuse 6 ist beispielsweise aus einem Kunststoff hergestellt. Darüber hinaus ist in dem Gehäuse 6 ein Trägerelement 14 angeordnet, welches als ein metallischer Kühlkörper ausgeführt ist. Der Kühlkörper ist beispielsweise aus Kupfer, Aluminium oder einer deren Legierungen hergestellt. Auf dem Kühlkörper sind eine dielektrische Materiallage 16, welche insbesondere Aluminiumoxid, Aluminiumnitrid oder einen organischen elektrisch isolierenden und thermisch leitfähigen Werkstoff enthält, und eine Metallisierung 18, welche beispielsweise Kupfer, Gold, Molybdän, Silber oder eine deren Legierungen enthält, angeordnet. Die Metallisierung 18 weist eine ebene Oberfläche 20 auf, welche eine xy-Ebene sowie eine senkrecht auf der Oberfläche 20 stehende z-Achse definiert. Die dielektrische Materiallage 16 kann mit dem Kühlkörper verpresst oder adhäsiv verbunden sein. Alternativ kann auf dem Kühlkörper ein Substrat, insbesondere als DCB (Direct Copper Bonded) Substrat, angeordnet sein. Das Substrat kann unter anderem stoffschlüssig, beispielsweise durch Löten auf dem Kühlkörper verbunden sein.

Das Halbleiterelement 4 ist mittels eines ersten Presskontakts 22 über die dielektrische Materiallage 16 kraftschlüssig mit dem Trägerelement 14 verbunden. Durch die dielektrische Materiallage 16 wird eine elektrisch isolierende und thermisch leitende Verbindung zwischen dem Halbleiterelement 4 und dem Trägerelement 14 hergestellt. Über den ersten Presskontakt 22 wird eine orthogonal zur Oberfläche 20 wirkende Kraft F übertragen, mittels welcher das Halbleiterelement 4 fixiert auf dem Trägerelement 14 fixiert wird.

Ein metallisches Kontaktierungselement 24 ist mit dem zweiten Leistungskontakt 10 des Halbleiterelements 4 verbunden und fungiert als Bufferschicht, welche die Kraft F vom Presskontakt 22 verteilt, sodass ein Einleiten von Druckspitzen in das empfindliche Halbleiterelement 4 verhindert wird. Das metallische Kontaktierungselement 24 kann unter anderem als Metallplättchen, welcher Kupfer und/oder Molybdän enthält, ausgeführt sein und eine Dicke im Bereich von 25 µm bis 250 µm aufweisen. Die Verbindung des metallischen Kontaktierungselements 24 zum Halbleiterelement 4 erfolgt stoffschlüssig über eine Sinterschicht 26, kann jedoch auch durch Löten erfolgen. Alternativ kann das metallische Kontaktierungselement 40 mittels eines thermischen Spritzverfahrens, insbesondere in Form von Kupfer- und/oder Molybdänpartikeln, aufgesprüht werden.

Zusätzlich zur mechanischen Fixierung erfolgt die elektrische Kontaktierung zweiten Leistungskontakts 10 des Halbleiterelements 4 mittels des ersten Presskontakts 22. Eine Mehrzahl von, insbesondere äquidistant quadratisch oder rechteckförmig auf dem metallischen Kontaktierungselement 24 angeordneten ersten Presskontakten 22 (z.B. 2x2, 2x3, 3x3, 3x4 oder 4x4) führt zu einer verbesserten mechanischen Fixierung des Halbleiterelements 4, einer homogeneren Druckverteilung und einer niederohmigen elektrischen Kontaktierung. Ein zweiter Presskontakt 28 und ein dritter Presskontakt 30 sind kraftschlüssig mit der Oberfläche 20 der Metallisierung 18 zur elektrischen Kontaktierung des ersten Leistungskontakts 8 bzw. des Steuerkontakts 12 verbunden, wobei der Steuerkontakt 12 über zumindest ein Verdrahtungsmittel 32 mit der Metallisierung 18 verbunden ist. Das zumindest eine Verdrahtungsmittel 32 ist beispielsweise als Bonddraht oder Bondband ausgeführt, welches insbesondere durch Ultraschall-Drahtbonden verschweißt ist. Über die Presskontakte 22, 28, 30 wird das Trägerelement 14 an die Innenwand 34 des Gehäuses 6 gepresst. Zusätzlich kann das Trägerelement 14 stoffschlüssig, z.B. mittels Adhäsion, mit der Innenwand 34 des Gehäuses 6 verbunden sein.

Die Presskontakte 22, 28, 30 sind als Stromschienen, welche auch Busbars genannt werden, ausgeführt. Beispielsweise werden die Stromschienen aus Kupfer oder einer Kupferlegierung hergestellt. Zusätzlich oder alternativ können die Presskontakte 22, 28, 30 eine Feder, eine Schraube oder einen Bügel aufweisen. Über Dichtungselemente 36 werden die Stromschienen aus dem Gehäuse 6 geführt, sodass das Gehäuse 6 wasserdicht, insbesondere fluiddicht, abgedichtet ist.

Über einen Zulauf 38 wird eine elektrisch isolierende Kühlflüssigkeit 40 zugeführt, wobei eine Kühlmittelströmung 42 erzeugt wird und das Gehäuse 6, insbesondere vollständig mit der elektrisch isolierenden Kühlflüssigkeit 40 gefüllt wird. Die Kühlmittelströmung 42 wird über eine erste Leitvorrichtung 44, welche beispielsweise mit dem Gehäuse 6 und/oder dem Trägerelement 14 verbunden ist, durch zumindest einen Kanal 46, welcher durch das Trägerelement 14 verlaufend angeordnet ist, geleitet. Die erste Leitvorrichtung 44 kann beispielsweise Leitbleche und/oder ein Rohr umfassen. Der Kanal 46 kann unter anderem mäanderförmig durch das Trägerelement 14 verlaufen. Die aus dem Kanal 46 des Trägerelements 14 austretende Kühlmittelströmung 42 wird über eine zweite Leitvorrichtung 48, welche beispielsweise als Leitblech ausgeführt ist, umgelenkt, sodass die elektrisch isolierende Kühlflüssigkeit 40 über das Halbleiterelement 4 strömt, sodass das Halbleiterelement 4 in unmittelbarem Kontakt mit der Kühlmittelströmung 42 steht. Beispielsweise ist das Halbleiterelement 4 im Wesentlichen quaderförmig ausgeführt, wobei zumindest fünf der sechs Seitenflächen des quaderförmigen Halbleiterelement 4 mit der elektrisch isolierenden Kühlflüssigkeit 40 in Kontakt stehen. Ferner sind die vier Seitenflächen des quaderförmig ausgeführten Halbleiterelements 4, welche senkrecht zur xy-Ebene verlaufend angeordnet sind, vollständig mit der elektrisch isolierenden Kühlflüssigkeit 40 kontaktiert. Über einen Ablauf 50 wird die durch die während des Betriebes des Halbleiterelements 4 entstehende Abwärme erwärmte Kühlflüssigkeit 40 abgeführt, außerhalb des Gehäuses 6 gekühlt und über den Zulauf 38 wieder zugeführt.

Die elektrisch isolierende Kühlflüssigkeit 40 ist als eine Inertflüssigkeit ausgeführt, welche eine hohe Durchschlagsfestigkeit von mindestens 10 kV/mm, insbesondere 20 kV/mm aufweist. Unter anderem kommen Galden^{®} HS 240, 3M^{™} Novec^{™} oder 3M^{™} Fluorinert^{™} als elektrisch isolierende Kühlflüssigkeit 40 infrage. Die elektrisch isolierende Kühlflüssigkeit 40 ersetzt in der Halbleiteranordnung 2 eine üblicherweise verwendete Vergussmasse, welche beispielsweise aus einem schwer entfernbaren Silikonisolationsmaterial hergestellt ist. Die elektrisch isolierende Kühlflüssigkeit 40 kann sehr leicht aus dem Gehäuses 6 entfernt werden, sodass die Komponenten im Gehäuses 6 für Rezyklierungs- und Reparaturvorgänge frei zugänglich sind. Durch die Kühlmittelströmung 42, welche in unmittelbarem Kontakt mit dem Halbleiterelements 4 steht, wird eine verbesserte Entwärmung während des Betriebes der Halbleiteranordnung 2 erreicht. Durch eine derartige Immersionskühlung ist die Halbleiteranordnung 2, insbesondere für Rezyklierungs- und Reparaturvorgänge, einfach und zumindest zu einem großen Teil reversibel zerlegbar.

Ein Sensor 52, welcher unter anderem einen Temperatursensor, einen Spannungssensor und/oder einen Stromsensor umfassen kann, ist im Bereich des Halbleiterelements 4 angeordnet. Die Kühlmittelströmung 42 wird mit Hilfe von Sensordaten, welche mit Hilfe des Sensors 52 ermittelt werden, geregelt, um beispielsweise eine Temperatur des Halbleiterelements 4 innerhalb eines vorbestimmten Temperaturbereichs zu halten.

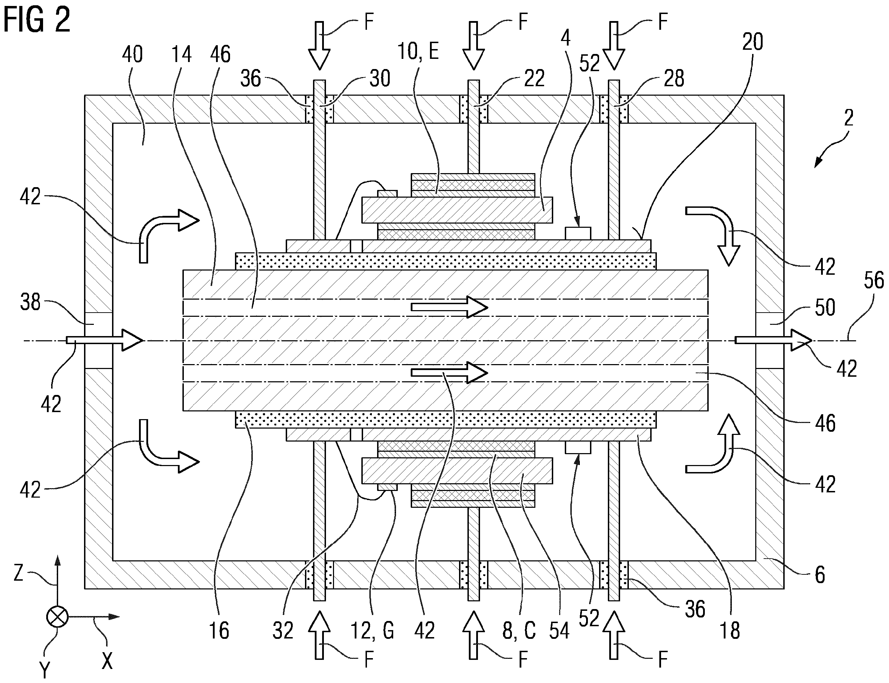

FIG 2 zeigt eine schematische Schnittdarstellung einer zweiten Ausführungsform einer Halbleiteranordnung 2. Auf einer dem Halbleiterelement 4 abgewandten Seite des in z-Richtung im Wesentlichen mittig im Gehäuse 6 angeordneten Trägerelements 14 ist ein weiteres Halbleiterelement 54 kraftschlüssig mit dem Trägerelement 14 verbunden ist. Somit sind die Halbleiterelemente 4, 54 beidseitig auf dem Trägerelement 14 angeordnet, welches durch die Presskontakte 22, 28, 30 im Wesentlichen mittig im Gehäuse 6 gehalten wird. Die Halbleiteranordnung 2 ist im wesentlichen achsensymmetrisch zu einer Mittenachse 56 angeordnet. Die elektrisch isolierende Kühlflüssigkeit 40 der Kühlmittelströmung 42 wird im Wesentlichen symmetrisch über die Halbleiterelemente 4, 54 und durch die achsensymmetrisch um die Mittenachse 56 angeordneten Kanäle 46 des Trägerelements 14 geleitet, sodass eine gleichmäßige Entwärmung der unmittelbar mit der Kühlmittelströmung 42 in Kontakt stehenden Halbleiterelemente 4, 54 erfolgt. Die Anordnung kann, wie in FIG 1, Leitvorrichtungen wie Leitbleche aufweisen, um die Kühlmittelströmung 42 gezielt und gleichmäßig mit den Halbleiterelementen 4, 54 in Kontakt zu bringen. Die weitere Ausführung der Halbleiteranordnung 2 in FIG 2 entspricht der Ausführung in FIG 1.

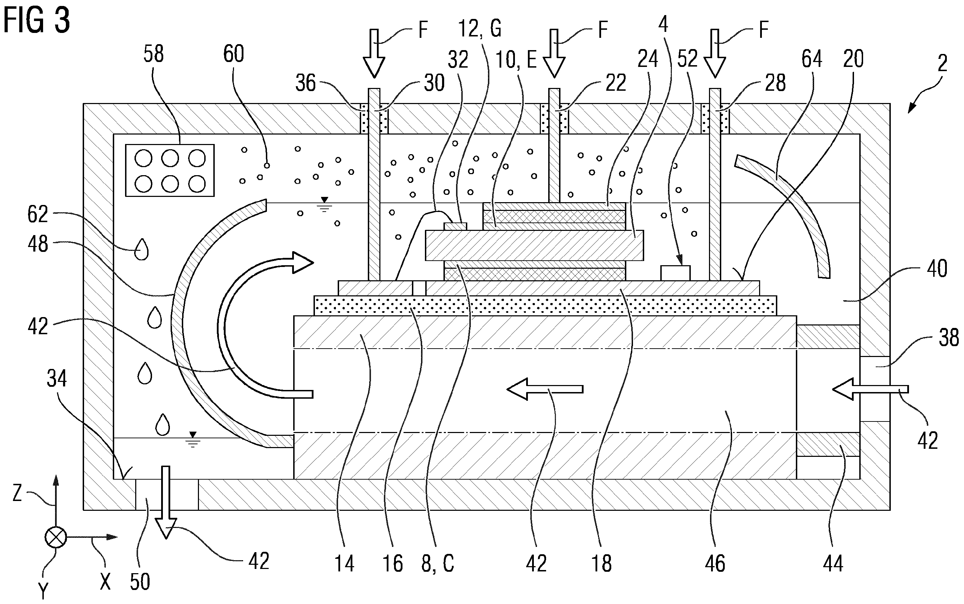

FIG 3 zeigt eine schematische Darstellung einer dritten Ausführungsform einer Halbleiteranordnung 2, wobei zumindest ein Teil der elektrisch isolierenden Kühlflüssigkeit 40 bei der unmittelbaren Kontaktierung mit dem Halbleiterelement 4 verdampft. Die Kühlflüssigkeit 40 ist eine Inertflüssigkeit, wie beispielsweise 3M^{™} Novec^{™}, deren Siedepunkt so konfiguriert ist, dass diese als Verdampfungskühlmittel bzw. Phasenwechselkühlmittel fungiert. Beispielsweise liegt der Siedepunkt bei 61, 76 oder 91°C. Durch eine derartige Phasenwechselkühlung können beispielsweise Wärmespitzen abgefedert werden. Über eine Kondensationsvorrichtung 58, insbesondere einen Wärmetauscher, wird das verdampfte Kühlmittel 60 kondensiert und dem Kreislauf als kondensiertes Kühlmittel 62 wieder zugeführt. Über eine dritte Leitvorrichtung 64 wird die Kühlmittelströmung 42 des durch die während des Betriebes des Halbleiterelements 4 entstehende Abwärme erwärmten aber nicht verdampften Kühlflüssigkeit 40 zu einem gemeinsamen Ablauf 50 geleitet. Alternativ kann das Gehäuse einen separaten Ablauf für das kondensierte Kühlmittel 62 aufweisen. Die weitere Ausführung der Halbleiteranordnung 2 in FIG 3 entspricht der Ausführung in FIG 1.

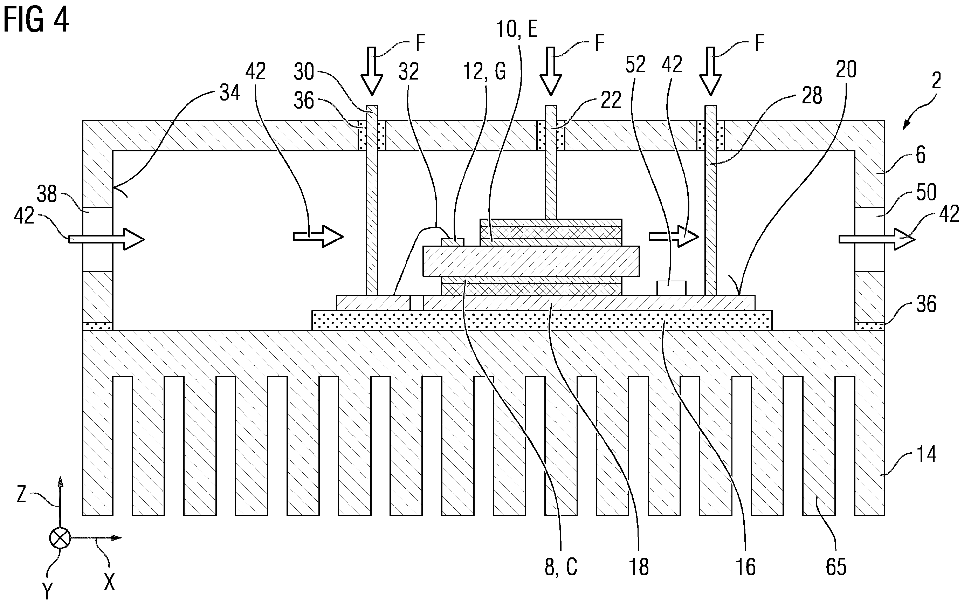

FIG 4 zeigt eine schematische Darstellung einer vierte Ausführungsform einer Halbleiteranordnung 2, wobei das Gehäuse 6 über eine Verbindung mit dem Trägerelement 14, insbesondere fluiddicht, geschlossen ist. Eine fluiddichte, insbesondere adhäsive, Verbindung des Gehäuses 6 mit dem Trägerelement 14 wird über zumindest ein Dichtungselement 36 hergestellt. Das Dichtungselement 36 kann beispielsweise einen abdichtenden Klebstoff aufweisen. Alternativ kann das Dichtungselement 36 ein umlaufendes Dichtungsband umfassen, wobei das Gehäuse 6 über das Dichtungsband auf den Kühlkörper gepresst und auf diese Weise fluiddicht geschlossen wird. Beispielsweise Schrauben oder Klemmen können das Gehäuse 6 dauerhaft und lösbar mit dem Kühlkörper verbinden. Das Trägerelement 14 ist beispielhaft als Kühlkörper, der aus Kupfer, Aluminium oder einer deren Legierungen hergestellt ist, ausgeführt. Der Kühlkörper weist Finnen 65 auf über welche die Während des Betriebes des Halbleiterelements 4 entstehende Wärme zusätzlich an die umgebende Luft abgebbar ist. Die Kühlmittelströmung 42 innerhalb des Gehäuses 6 verläuft im Wesentlichen in x-Richtung. Die weitere Ausführung der Halbleiteranordnung 2 in FIG 4 entspricht der Ausführung in FIG 1.

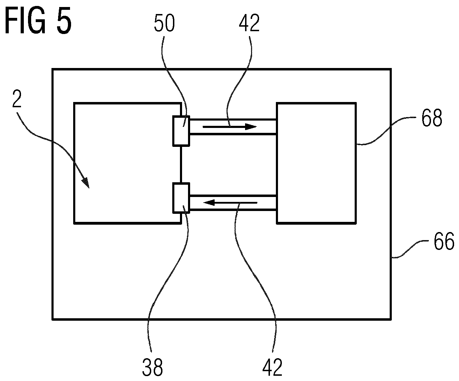

FIG 5 zeigt eine schematische Darstellung eines Stromrichters 66, welcher eine Halbleiteranordnung 2 sowie eine Kühlvorrichtung 68 umfasst. Die aus dem Ablauf 50 von der Halbleiteranordnung 2 abgegebene Kühlmittelströmung 42 wird über die Kühlvorrichtung 68, welche beispielsweise einen Wärmetauscher umfasst, gekühlt und über den Zulauf 38 wieder zugeführt. Der Stromrichter 66 kann mehr als eine Halbleiteranordnung 2 umfassen, welche mit zumindest einer Kühlvorrichtung 68 einen Kühlkreislauf ausbilden.

Zusammenfassend betrifft die Erfindung eine Halbleiteranordnung 2, insbesondere Leistungshalbleiteranordnung für einen Stromrichter 66, mit zumindest einem Halbleiterelement 4, wobei das zumindest eine Halbleiterelement 4 in einem geschlossenen Gehäuse 6 angeordnet ist. Um die Rezyklierbarkeit der Halbleiteranordnung 2 zu verbessern, wird vorgeschlagen, dass das Halbleiterelement 4 in unmittelbarem Kontakt mit einer Kühlmittelströmung 42 einer elektrisch isolierenden Kühlflüssigkeit 40, insbesondere Inertflüssigkeit, steht.

## Patentansprüche

1. Halbleiteranordnung (2), insbesondere Leistungshalbleiteranordnung für einen Stromrichter (66), mit zumindest einem Halbleiterelement (4),
wobei das zumindest eine Halbleiterelement (4) in einem geschlossenen Gehäuse (6) angeordnet ist,
**dadurch gekennzeichnet, dass**
das Halbleiterelement (4) in unmittelbarem Kontakt mit einer Kühlmittelströmung (42) einer elektrisch isolierenden Kühlflüssigkeit (40), insbesondere Inertflüssigkeit, steht.

2. Halbleiteranordnung (2) nach Anspruch 1,
wobei das Halbleiterelement (4), insbesondere mittels eines ersten Presskontakts (22), kraftschlüssig mit einem Trägerelement (14) verbunden ist.

3. Halbleiteranordnung (2) nach Anspruch 2,
wobei das Trägerelement (14) aus einem metallischen Werkstoff hergestellt ist und
wobei das Halbleiterelement (4) über eine dielektrische Materiallage (16) elektrisch isolierend mit dem Trägerelement (14) verbunden ist.

4. Halbleiteranordnung (2) nach einem der Ansprüche 2 oder 3, wobei das Trägerelement (14) zumindest einen Kanal (46) umfasst, durch welchen die Kühlmittelströmung (42) verläuft.

5. Halbleiteranordnung (2) nach einem der Ansprüche 2 bis 4, umfassend eine zweite Leitvorrichtung (48), welche konfiguriert ist, die durch den zumindest einen Kanal (46) des Trägerelements (14) verlaufende Kühlmittelströmung (42) über das Halbleiterelement (4) zu leiten.

6. Halbleiteranordnung (2) nach einem der Ansprüche 2 bis 5, wobei auf einer dem Halbleiterelement (4) abgewandten Seite des Trägerelements (14) ein weiteres Halbleiterelement (54), insbesondere mittels eines ersten Presskontakts (22), kraftschlüssig mit dem Trägerelement (14) verbunden ist.

7. Halbleiteranordnung (2) nach einem der vorherigen Ansprüche,
wobei die elektrisch isolierende Kühlflüssigkeit (40) als Phasenwechselkühlmittel ausgeführt ist.

8. Halbleiteranordnung (2) nach Anspruch 7,
wobei in dem geschlossenen Gehäuse (6) eine Kondensationsvorrichtung (58) zur Kondensation eines verdampften Kühlmittels (60) angeordnet ist.

9. Stromrichter (66) mit mindestens einer Halbleiteranordnung (2) nach einem der vorherigen Ansprüche.

10. Verfahren zur Kühlung eines Halbleiterelements (4) in einer Halbleiteranordnung (2), insbesondere einer Leistungshalbleiteranordnung für einen Stromrichter (66), mit zumindest einem Halbleiterelement (4),
wobei das zumindest eine Halbleiterelement (4) in einem geschlossenen Gehäuse (6) angeordnet ist,
**dadurch gekennzeichnet, dass**
wobei das Halbleiterelement (4) in unmittelbarem Kontakt mit einer Kühlmittelströmung (42) einer elektrisch isolierenden Kühlflüssigkeit (40), insbesondere Inertflüssigkeit, gebracht wird.

11. Verfahren nach Anspruch 10,
wobei das Halbleiterelement (4), insbesondere mittels eines ersten Presskontakts (22), kraftschlüssig mit einem Trägerelement (14) verbunden wird.

12. Verfahren nach Anspruch 11,
wobei die Kühlmittelströmung (42) durch zumindest einen Kanal (46) des Trägerelements (14) geleitet wird.

13. Verfahren nach Anspruch 12,
wobei die durch den zumindest einen Kanal (46) des Trägerelements (14) geleitete Kühlmittelströmung (42) mittels einer zweiten Leitvorrichtung (48) über das Halbleiterelement (4) geleitet wird.

14. Verfahren nach einem der Ansprüche 10 bis 13,
wobei auf einer dem Halbleiterelement (4) abgewandten Seite des Trägerelements (14) ein weiteres Halbleiterelement (54), insbesondere mittels eines ersten Presskontakts (22), kraftschlüssig mit dem Trägerelement (14) verbunden wird,
wobei die Kühlmittelströmung (42), insbesondere symmetrisch, über die Halbleiterelemente (4, 54) geleitet wird.

15. Verfahren nach einem der Ansprüche 10 bis 14,
wobei mittels der elektrisch isolierenden Kühlflüssigkeit (40) eine Phasenwechselkühlung erfolgt.

16. Verfahren nach einem der Ansprüche 10 bis 15,
wobei ein Sensor (52) im Bereich des Halbleiterelements (4) angeordnet wird,
wobei die Kühlmittelströmung (42) anhand von Sensordaten, welche mit Hilfe des Sensors (52) ermittelt werden, geregelt wird.

17. Verwendung einer Kühlmittelströmung (42) einer elektrisch isolierenden Kühlflüssigkeit (40), insbesondere Inertflüssigkeit, zum Kühlen eines Halbleiterelements (4) in einem geschlossenen Gehäuse (6),
wobei die Kühlmittelströmung (42) in unmittelbarem Kontakt mit dem zumindest einen Halbleiterelement (4) steht.

18. Computerprogrammprodukt, welches als digitaler Zwilling einer Halbleiteranordnung (2) nach einem der Ansprüche 1 bis 8 ausgebildet ist und
welches bei einem Simulieren des Betriebsverhaltens einer korrespondierend ausgebildeten Halbleiteranordnung (2) verwendet wird.
